# EUROPÄISCHE PATENTSCHRIFT

(11) **EP 4 467 701 B1**
(45) Veröffentlichungstag und Bekanntmachung des Hinweises auf die Patenterteilung: **26.08.2026**
(21) Anmeldenummer: 23198639.9
(22) Anmeldetag: 20.09.2023
(51) Int. Cl.: D04B 27/02

(54) **TEXTILWERKZEUG, TEXTILWERKZEUGVERBUND, TEXTILMASCHINE UND VERFAHREN ZUR HERSTELLUNG EINES TEXTILEN FLÄCHENGEBILDES**
TEXTILE TOOL, TEXTILE TOOL COMPOSITE, TEXTILE MACHINE AND METHOD FOR PRODUCING A TEXTILE SHEET MATERIAL
OUTIL TEXTILE, ENSEMBLE D'OUTILS TEXTILES, MACHINE TEXTILE ET PROCÉDÉ DE FABRICATION D'UNE STRUCTURE TEXTILE PLANE

(30) Priorität: 24.05.2023 EP 23175153
(43) Veröffentlichungstag der Anmeldung: 27.11.2024
(73) Patentinhaber: KARL MAYER R&D GmbH, 63179 Obertshausen (DE)
(72) Erfinder: HARMELING, Frank, 73110 Hattenhofen (DE); SCHULER, Günter, 64850 Schaafheim (DE); STOCKENHOFEN, Frank, 63165 Mühlheim am Main (DE); SCHADT, Heiko, 63853 Mömlingen (DE); SAAL, Torsten, 64823 Groß-Umstadt (DE); OTT, Christian, 63165 Mühlheim am Main (DE); DISSER, Daniel, 63791 Karlstein (DE); ARNOLD, Matthias, 63755 Alzenau (DE)
(74) Vertreter: MERH-IP Matias Erny Reichl Hoffmann Patentanwälte PartG mbB

(56) Entgegenhaltungen:
- EP-A1- 0 844 469
- EP-B1- 2 280 106
- WO-A1-2011/072664
- JP-A- S6 228 453

## Beschreibung

### Technisches Gebiet

Die vorliegende Erfindung betrifft ein Textilwerkzeug, einen Textilwerkzeugverbund eine Textilmaschine und ein Verfahren zur Herstellung eines textilen Flächengebildes.

### Hintergrund der Erfindung

Im Zuge der automatisierten Fertigung von textilen Flächengebilden kommen Textilmaschinen zum Einsatz, die eine Vielzahl von einzelnen Textilfäden miteinander auf teilweise unterschiedliche Weisen verarbeiten, um so ein textiles Flächengebilde herzustellen.

Hierzu sind im technischen Gebiet der Textilverarbeitung Web-, Strick- oder Wirkmaschinen bekannt, deren Funktionsweisen zur Verarbeitung der Textilfäden sich grundlegend unterscheiden. So erfolgt beispielsweise die Verarbeitung an einer Webmaschine durch winkliges Verweben der Textilfäden, die abwechselnd über- und untereinander verlaufen, wohingegen die Verarbeitung an der Wirkmaschine durch Maschenbildung erfolgt.

Unbenommen dieser Unterschiede werden bei sämtlichen fadenverarbeitenden Textilmaschinen die einzelnen Textilfäden einem Arbeitsbereich der Textilmaschine zugeführt, in dem die Verarbeitung durch Relativbewegungen mehrerer mit den Textilfäden in Kontakt stehenden Textilwerkzeuge erfolgt.

Im Wege der Verarbeitung werden die Textilwerkzeuge dabei durch abrasive Eigenschaften der Textilfäden, Reibung, Prozesskräfte, chemische Substanzen usw. in Mitleidenschaft gezogen, was unter anderem zu Verschleiß oder zu Veränderungen der Reibwerte im Kontakt mit den Textilfäden führt. Dies beeinflusst wiederum die Genauigkeit der Fadenführung am Textilwerkzeug und führt ebenso zu zunehmender Beschädigung der Textilfäden, was sich negativ auf die Qualität des textilen Flächengebildes auswirkt. Ab einem gewissen Schädigungsgrad sind die Textilwerkzeuge letztlich nicht mehr verwendbar und müssen ausgetauscht werden, was aufgrund der Vielzahl von Textilwerkzeugen in einer Textilmaschine zu langen Stillstandzeiten der selbigen führt.

Um vor diesem Hintergrund die Widerstandsfähigkeit der Textilwerkzeuge und damit auch deren Einsatzdauer zu erhöhen, weisen diese zumindest im fadenführenden Bereich eine Beschichtung auf, die im Vergleich zu einem darunter liegenden Werkzeugkern den obenstehenden Belastungen besser standhalten kann. Dabei sind unter anderem auch die unterschiedlichen Arten von Textilfäden im Auge zu behalten, die von sehr robusten Textilfäden, die die Textilwerkzeuge überdurchschnittlich verschleißen, bis hin zu hoch sensitiven Textilfäden reichen, die bereits durch geringste Unregelmäßigkeiten im Kontakt mit dem Textilwerkzeug beschädigt werden können.

Die auf einen Werkzeugkern der Textilwerkzeuge aufgebrachten Beschichtungen umfassen dabei üblicherweise eine Vielzahl verschiedenster Materialschichten, von denen die äußerste Materialschicht eine Verschleißschutzschicht ist, die zumindest im Vergleich zum Material des Werkzeugkerns eine höhere Verschleißbeständigkeit aufweist, insbesondere in der Paarung mit einem Textilfaden. Die Verschleißschutzschicht sollte dabei so gewählt werden, dass diese den später mit dieser in Kontakt stehenden Textilfaden möglichst nicht beschädigt und zudem ein leichtgängiges Gleiten desselbigen ermöglicht.

Zusätzlich zur Verschleißschutzschicht kommen weitere zwischen dem Werkzeugkern und der äußersten Verschleißschutzschicht angeordnete Materialschichten zum Einsatz, beispielsweise um die Hafteigenschaften der Beschichtung am Werkzeugkern zu verbessern. Dabei sind eine Vielzahl von Faktoren zu berücksichtigen, wie beispielsweise Materialen und jeweilige Schichtdicken, die das Textilwerkzeug auf unterschiedliche Weise beeinflussen.

Ein derartiges, als Lochnadel ausgeführtes Textilwerkzeug mit mehreren Materialschichten ist beispielsweise aus der DE 4 491 289 C2 bekannt, bei der drei Materialschichten auf einen Werkzeugkern aus Stahl aufgebracht sind, von denen eine äußerste Kohlenstoffschicht als Verschleißschutzschicht fungiert.

Derartige Textilwerkzeuge sind mit einer zeitaufwändigen Herstellung verbunden, die eines sequentiellen Aufbringens einer Vielzahl von Materialschichten bedarf, von denen jede in der Regel auf das Einstellen einer anderen Eigenschaften des Textilwerkzeugs abzielt, seien es mechanische, thermische oder chemische Eigenschaften.

Obgleich die Vielzahl an Materialschichten die Eignung des Textilwerkzeugs für den späteren Einsatz bei der Herstellung textiler Flächengebilde verbessert, hat sich jedoch gezeigt, dass diese Textilwerkzeuge eher anfällig für Abplatzungen oder Ablösungen der Beschichtung während des Einsatzes sind und ebenso auch, dass die Vielzahl von Materialschichten zu einer vergleichsweise hohen Ausschussquote bei der Herstellung führt.

Aus der JP S6 228 453 A ist zudem ein Textilwerkzeug mit einer Metallnitrid-Beschichtung bekannt, bei der ein Stickstoffgehalt in der Beschichtung variiert.
Weiterer Stand der Technik ist zudem aus der EP 0 844 469 A1, die ein Verfahren zum Herstellen von mechanisch beanspruchbaren Komponenten mit einem mit einer tribologischen Beschichtung versehenen Substrat offenbart, und aus der WO 2011 072 664 A1 bekannt, die ein Beschichtungssystem mit einer eingebetteten Festschmierstoffstruktur zeigt.

### Zusammenfassung der Erfindung

Eine Aufgabe der vorliegenden Erfindung ist es nun, eine gegenüber dem Stand der Technik wirtschaftlichere und langlebigere Möglichkeit zur maschinellen Herstellung textiler Flächengebilde bereitzustellen, mit der eine hohe Produktqualität des herzustellenden Flächengebildes beibehalten werden kann.

Zur Lösung dieser Aufgabe wird ein beschichtetes Textilwerkzeug nach Anspruch 1, ein Textilwerkzeugverbund nach Anspruch 13, eine Textilmaschine zur Herstellung eines textilen Flächengebildes nach Anspruch 14 und ein Verfahren zur Herstellung eines textilen Flächengebildes nach Anspruch 15 bereitgestellt.

Die jeweiligen abhängigen Ansprüche beziehen sich dabei auf bevorzugte Ausführungsformen, die jeweils für sich genommen oder in Kombination bereitgestellt werden können.

Gemäß eines ersten Aspekts der Erfindung wird ein Textilwerkzeug zum Einsatz in einer Textilmaschine bereitgestellt, das einen Arbeitsabschnitt zum Einwirken auf einen Textilfaden im Zuge einer Herstellung eines textilen Flächengebildes aufweist, wobei das Textilwerkzeug einen Werkzeugkern aus einem Kernmaterial umfasst, auf den zumindest im Arbeitsabschnitt eine Beschichtung zum Verschleißschutz aufgebracht ist. Die Beschichtung umfasst eine Gradientenschicht, die aus einer Materialmischung aus zumindest einem ersten Beschichtungsmaterial und einem Verschleißschutzmaterial als zweitem Beschichtungsmaterial aufgebaut ist, wobei eine Konzentration des Verschleißschutzmaterials zumindest in einer Dickenrichtung der Gradientenschicht variiert. Das zweite Beschichtungsmaterial ist dabei ein anderes Material als das erste Beschichtungsmaterial. Der Werkzeugkern des Textilwerkzeugs ist derart ausgestaltet ist, dass ein minimaler Krümmungsradius einer Oberfläche im Arbeitsabschnitt des Textilwerkzeugs größer gleich 40 µm ist. Weiter bevorzugt ist der minimale Krümmungsradius größer gleich 50 µm und besonders bevorzugt größer gleich 70 µm.

Die Bezeichnungen "zum Verschleißschutz", "verschleißfest" oder dergleichen sind in Bezug auf die Beschichtung im Kontext der Erfindung so zu verstehen, dass die Beschichtung eine höhere Widerstandsfähigkeit gegen Materialabtrag und/oder eine höhere Festigkeit und/oder eine höhere Härte aufweist als das darunter liegende Kernmaterial, aus dem der Werkzeugkern hergestellt ist, üblicherweise Stahl oder eine andere Metalllegierung.

Unter Beschichtung ist dabei jedweder auf den bestehenden Werkzeugkern aufgebrachter Verbund zu verstehen, der insbesondere aus vom Kernmaterial abweichenden Materialien zusammengesetzt ist. Es kann sich hierbei um einzelne aber auch um mehrere Schichten handeln, die in beliebiger Reihenfolge aufgebracht sein können.

Unter dem textilen Flächengebilde ist jedwedes Textilerzeugnis unabhängig von einem jeweiligen Herstellungsverfahren zu verstehen. Beispiele hierfür sind Gewebe, Maschenwaren, Filze, Teppiche, Tufting-Teppiche, Vliesstoffe, Bobinet, Netze, Geflechte, Gelege, Multitextilien oder Nähwirkwaren.

Zur Herstellung des textilen Flächengebildes erfolgt die Verarbeitung einer Vielzahl von Textilfäden durch die in einem Arbeitsbereich der Textilmaschine angeordneten Textilwerkzeuge (im Falle einer Wirkmaschine zum Beispiel durch Wirkwerkzeuge, wie Loch- und Schiebernadeln), die sich relativ zueinander im Arbeitsbereich bewegen, insbesondere mittels entsprechender Antriebe und Getriebe, um die Vielzahl von Textilfäden miteinander zu vermaschen, zu verknüpfen, zu verweben, zu verstricken oder dergleichen.

Durch den Einsatz der die Gradientenschicht umfassenden Beschichtung kann ein Textilwerkzeug mit einer hohen Lebens- bzw. Betriebsdauer bereitgestellt werden.

So bricht die Gradientenschicht mit dem konventionellen Konzept mehrerer übereinander auf dem Werkzeugkern aufgetragener Schichten, beispielsweise in Form einer Haftvermittlungsschicht oder einer Indikatorschicht oder einer Korrosionsschutzschicht und einer auf dieser wiederum aufgetragenen Verschleißschutzschicht, und stellt eine einzelne Schicht bereit, die vorteilhafte mechanische, physikalische oder chemische Eigenschaften des ersten Beschichtungsmaterials mit den Verschleiß reduzierenden Eigenschaften des Verschleißschutzmaterials in einer einzigen Schicht kombiniert. Zu den vorteilhaften Eigenschaften des ersten Beschichtungsmaterials können exemplarisch Haftung verbessernden Eigenschaften eines Haftvermittlungsmaterials, die chemische Widerstandsfähigkeit verbessernde Eigenschaften eines Korrosionsschutzmaterials oder eine die Verschleißdetektion erleichterndes Indikatormaterial sein.

Jeder Übergang zwischen zwei Materialien bzw. zwischen zwei Schichten aus unter unterschiedlichen Materialien stellt eine Schnittstelle dar, an der durch den Materialwechsel bedingt Sprünge in unterschiedlichsten Parametern auftreten, z. B. der Festigkeit, des thermischen Ausdehnungskoeffizienten etc., was wiederum zu Bereichen führt, in denen vergleichsweise hohe mechanische Spannungen, insbesondere Spannungspeaks, in Folge thermischer oder mechanischer Belastung des Textilwerkzeugs auftreten. Durch diese Spannungen bzw. Spannungspeaks wird das dortige Material entsprechend stark beansprucht und neigt daher zum Versagen, beispielsweise in Form von plastischer Verformung, Abplatzungen einzelner Schichten oder Rissbildung.

Durch die Gradientenschicht wird im Vergleich zu obigem Beispiel mit Haftvermittlungs-/Indikator/Korrosionsschutzschicht und separater Verschleißschutzschicht eine Beschichtung auf dem Werkzeugkern bereitgestellt, die eine der vorstehend beschriebenen Schnittstellen weniger aufweist und damit auch weniger Bereiche mit erhöhten Spannungen bzw. Spannungspeaks aufweist.

Dadurch fallen die im Textilwerkzeug auftretenden Spannungen infolge thermischer oder mechanischer Belastung (zum Beispiel aufgrund unterschiedlicher thermischer Ausdehnungskoeffizienten) wesentlich gleichmäßiger aus, was sich wiederum positiv auf die Widerstandsfähigkeit des Textilwerkzeugs auswirkt.

Dies gewährleistet wiederum eine lange Lebensdauer der Textilwerkzeuge und senkt damit Stillstandzeiten als auch Wartungskosten der Textilmaschine, da die Textilwerkzeuge nun seltener ausgetauscht werden müssen.

Ferner handelt es sich bei der Gradientenschicht im Vergleich zur im Stand der Technik bekannten Variante mit zwei separaten Schichten lediglich um eine einzige Schicht, wodurch Herstellungszeiten und auch eine Ausschussquote bei der Herstellung reduziert werden können, was wiederum Kosten einspart.

Durch die variierende Konzentration des Verschleißschutzmaterials in Dickenrichtung kann dabei ein besonders gleichmäßiger Übergang der durch das erste Beschichtungsmaterial verbesserten Eigenschaften (z. B. Haftung, Korrosionsschutz, Indikator) in die den Verschleiß reduzierenden Eigenschaften der Gradientenschicht umgesetzt werden.

Die Bezeichnung Konzentration soll hierbei gleichbedeutend mit einem Anteil oder einem Massenanteil eines Bestandteils der Materialmischung verstanden werden und kann beispielsweise in ppm oder Massen-% angegeben werden.

Unter Dickenrichtung kann dabei die an einem ausgezeichneten Punkt des Textilwerkzeugs orthogonal zu einer Oberfläche der Gradientenschicht oder zur Oberfläche des darunter liegenden Werkzeugkerns verlaufende Normalenrichtung verstanden werden. Je nach Kontur des Textilwerkzeugs können Dickenrichtungen unterschiedlicher Punkte parallel oder aber auch winklig zueinander verlaufen.

Unter Materialmischung soll dabei verstanden werden, dass jedwedes Volumenelement der Materialmischung bzw. der aus diese gebildeten Gradientenschicht sowohl das Verschleißschutzmaterial als auch das erste Beschichtungsmaterial enthält. Die schließt allerdings nicht aus, dass eine Konzentration des Verschleißschutzmaterials bei Annäherung an ein Beschichtungsende, insbesondere in Dickenrichtung, den Maximalwert von 100 Massen-% oder den Minimalwert von 0 Massen-% erreicht.

Die in Dickenrichtung variierende Konzentration soll dabei so verstanden werden, dass es zumindest einen Punkt auf der Gradientenschicht gibt, bezüglich dessen die Konzentration entlang der zugehörigen Dickenrichtung, die dabei der punktspezifischen Dickenrichtung durch den besagten Punkt entspricht, über die Dicke der Gradientenschicht hinweg variiert.

Gemäß dessen ist die Konzentration des Verschleißschutzmaterials nicht über die gesamte Dicke der Gradientenschicht hinweg konstant, sondern veränderlich und kann beispielsweise über eine Konzentrationsfunktion in Abhängigkeit von zum Beispiel der absoluten oder prozentualen Schichtdicke in der Dickenrichtung der Gradientenschicht angegeben werden.

Vorzugsweise weist die Gradientenschicht einen Oberflächenabschnitt auf, bezüglich dessen die Konzentration für jede Dickenrichtung der im Oberflächenabschnitt liegenden Punkte variiert. Alternativ kann die variierende Konzentration aber auch als Mittelwert über alle Punkte des Oberflächenabschnitts verstanden werden. Vorzugsweise beträgt besagter Oberflächenabschnitt 10 bis 100 % einer Oberfläche der Gradientenschicht.

Der Werkzeugkern des Textilwerkzeugs ist derart ausgestaltet, dass Krümmungsradien einer Oberfläche im Arbeitsabschnitt des Textilwerkzeugs größer gleich 40 µm sind, weiter bevorzugt größer gleich 50 µm und besonders bevorzugt größer gleich 70 µm.

In anderen Worten liegt ein minimal zulässiger Krümmungsradius im Arbeitsabschnitt bei 40 µm bzw. bei 50 µm oder 70 µm.

Dadurch können Druckeigenspannungen der Beschichtung an den gekrümmten Stellen reduziert werden, was wiederum das Risiko eines Abplatzens der Beschichtung zusätzlich reduziert.

Das Verschleißschutzmaterial dient dem Verschleißschutz und weist eine höhere Verschleißbeständigkeit als das Kernmaterial auf, insbesondere als das Kernmaterial und das erste Beschichtungsmaterial.

Die Verschleißbeständigkeit kann über einen messbaren Verschleißkennwert für die Beständigkeit gegen abrasiven Verschleiß in einer Materialpaarung (hier mit einem Textilfaden) angegeben werden. Der Verschleißkennwert des Verschleißschutzmaterials fällt dabei größer aus als ein Verschleißkennwert des Kernmaterials und insbesondere auch größer als ein Verschleißkennwert des ersten Beschichtungsmaterials

Bei dem Verschleißkennwert kann es sich beispielsweise um eine Verschleißrate oder um ein Verhältnis von Verschleißraten handeln kann.

Die Verschleißrate beschreibt dabei die Größe eines Verschleißes pro Versuchseinheit, wobei die Versuchseinheit beispielsweise durch Versuchsdauer (Zeit) oder durch Gleitdistanz bemessen werden. Die Größe des Verschleißes für eine Materialpaarung kann als abgetragenes Volumen oder als abgetragene Masse gemessen werden.

Bei einer Materialpaarung mit einem Textilfaden kann beispielsweise ein Versuchsaufbau gewählt werden, bei dem eine gewisse Länge eines Textilfadens mit einer definierten Kraft über einen mit dem zu vermessenden Material beschichteten Festkörper gezogen wird. Die Geometrie des Festkörpers, die Kraft und die Länge des Textilfadens sollten zwecks Vergleichbarkeit von Versuchen konstant gehalten werden. Ein Maß für die Verschleißbeständigkeit des vermessenen Materials ist die Größe des dabei auftretenden Verschleißes bzw. der Verschleißrate. Je kleiner der Verschleiß bzw. die Verschleißrate ausfällt, desto größer ist die Verschleißbeständigkeit.

Als Verschleißkennwert kann dabei der bei dem Versuch gemessene Verschleiß bzw. die gemessene Verschleißrate angesetzt werden, vorzugsweise eignet sich aber ein dimensionsloser Verschleißkennwert in Form eines Quotienten von der Größe des Verschleißes eines Referenzmaterials, insbesondere von Hartchrom, zu der Größe des Verschleißes des zu vermessenden Materials. Ein Quotient größer 1 bedeutet dabei, dass das vermessene Material verschleißbeständiger ist als das Referenzmaterial, zum Beispiel als Chrom.

Das erste Beschichtungsmaterial ist ein anderes Material als das Verschleißschutzmaterial und kann insbesondere ein Haftvermittlungsmaterial, ein Indikatormaterial oder ein Korrosionsschutzmaterial sein, so lange es gegenüber dem Kernmaterial und/oder dem Verschleißschutzmaterial verbesserte Eigenschaften in einem ausgewählten Funktionsbereich bietet, z. B. Haftungsverbesserung, Korrosionsschutzverbesserung, Detektionsverbesserung, usw.

Ist das erste Beschichtungsmaterial ein Haftungsmaterial dient dieses der Adhäsions- bzw. Haftungsverbesserung der Beschichtung an dem Werkzeugkern und weist eine bessere Haftung auf dem Kernmaterial auf als das Verschleißschutzmaterial. Durch die Adhäsionsverbesserung wird das Risiko eines Ablösens bzw. eines Abplatzens der Beschichtung reduziert.

Die Haftung kann über einen messbaren Haftungskennwert für die Beständigkeit gegen Schichtabplatzung in einer Materialpaarung angegeben werden. Der Haftungskennwert des Haftvermittlungsmaterials in Bezug auf das Kernmaterial fällt dabei größer aus als ein Haftungskennwert des Verschleißschutzmaterials in Bezug auf das Kernmaterial.

Bei dem Haftungskennwert kann es sich beispielsweise um eine Haftfestigkeit oder um ein Verhältnis von Haftfestigkeiten handeln.

Die Haftfestigkeit eines als Beschichtung aufgetragenen Materials auf ein Kernmaterial kann beispielsweise in einem Verfahren nach DIN 4856:2018-02 oder in einem Ritztest nach DIN EN 1071-3 bestimmt werden. Je größer die Haftfestigkeit ausfällt, desto besser ist die Haftung. Zwecks Vergleichbarkeit zweier Beschichtungsmaterialien wird verständlicherweise das gleiche Kernmaterial verwendet, bei dem es sich insbesondere um das Kernmaterial des Textilwerkzeugs handelt.

Als Haftungskennwert kann dabei die bei dem Versuch gemessene Haftfestigkeit angesetzt werden. Vorzugweise eignet sich aber ein dimensionsloser Haftungskennwert in Form eines Quotienten aus der Haftfestigkeit des vermessenen Materials zur Haftfestigkeit eines Referenzmaterials, insbesondere von Hartchrom. Ein Quotient größer 1 bedeutet dabei, dass das vermessene Material eine bessere Haftung aufweist als das Referenzmaterial, z. B. als Chrom.

Ist das erste Beschichtungsmaterial ein Korrosionsschutzmaterial dient dieses der Korrosionsschutzverbesserung der Beschichtung und weist eine höhere Korrosionsbeständigkeit auf als das Verschleißschutzmaterial und/oder als das Kernmaterial.

Die Korrosionsbeständigkeit kann hierbei beispielsweise über Korrosionsbeständigkeitsmessungen bestimmt werden, bei dem das zu testende Material als Objekt einer Korrosionsatmosphäre (z.B. Salznebel, Immersion in Korrosionslösungen, Schwefeldioxid-Umgebung, vorgegebene Klimabedingungen, Wasserdampfkondensat u. ä.) ausgesetzt wird und im Anschluss ein Korrosionsanteil am gesamten Objekt bestimmt wird.

Ist das erste Beschichtungsmaterial ein Indikatormaterial dient dieses der Verbesserung der Verschleißdetektion der Beschichtung. Beispielsweise kann es sich um Indikatormaterial zur optischen Verschleißdetektion oder zur elektrischen Verschleißdetektion handeln.

Im Falle der optischen Verschleißdetektion weist das Indikatormaterial eine andere Farbe auf als das Verschleißschutzmaterial und insbesondere auch eine andere Farbe als das Kernmaterial, vorzugsweise derart, dass die unterschiedlichen Farbe mit bloßem Auge erkennbar sind.

Vorzugsweise variiert dabei eine Konzentration des Indikatormaterials in Dickenrichtung der Gradientenschicht, sodass über Farbabstufungen in Dickenrichtung der Gradientenschicht auf einen relativen Verschleißzustand rückgeschlossen oder dieser zumindest abgeschätzt werden kann, also wie viel Prozent der Gradientenschicht in Dickenrichtung bereits abgetragen wurden.

Im Falle der elektrischen Verschleißdetektion kann das Indikatormaterial eine andere elektrische Leitfähigkeit als das Kern- und/oder das Verschleißschutzmaterial aufweisen, insbesondere eine gegenüber diesen stark erhöhte oder stark verringerte. Ein Abtrag der Gradientenschicht führt damit zu vergleichsweise starken Änderungen der Leitfähigkeitseigenschaften, sodass über deren Messung ein Verschleißzustand detektiert werden kann.

Vorzugsweise umfasst die Materialmischung der Gradientenschicht noch ein drittes Beschichtungsmaterial, das insbesondere ein Haftvermittlungsmaterial, ein Indikatormaterial oder ein Korrosionsschutzmaterial ist.

Auf diese Weise kann die Gradientenschicht um zwei Funktionen erweitert werden, sodass zum Beispiel das erste Beschichtungsmaterial ein Haftvermittlungsmaterial und das dritte Beschichtungsmaterial ein Indikatormaterial, oder das erste Beschichtungsmaterial ein Haftvermittlungsmaterial und das dritte Beschichtungsmaterial ein Korrosionsschutzmaterial, oder das erste Beschichtungsmaterial ein Indikatormaterial und das dritte Beschichtungsmaterial ein Korrosionsschutzmaterial ist.

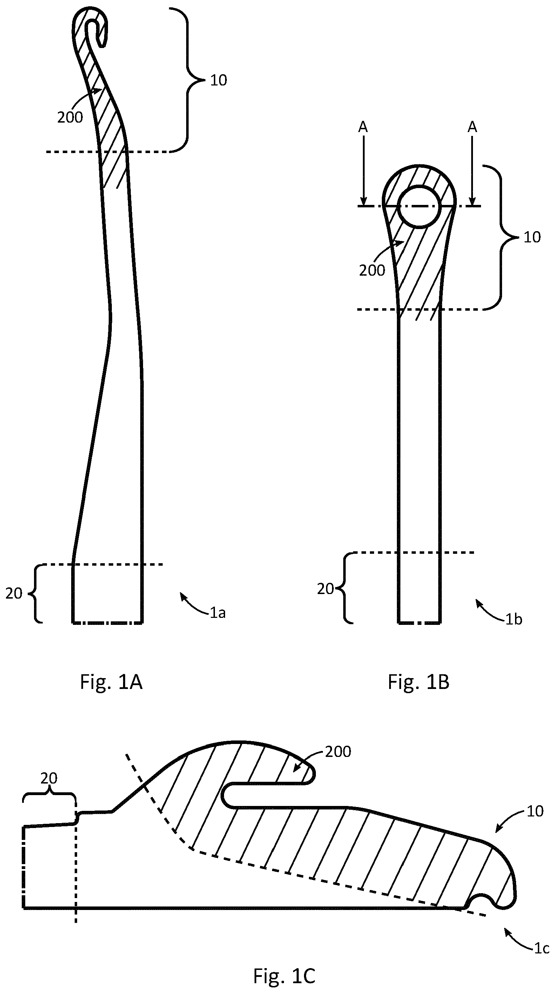

Vorzugsweise handelt es sich bei dem Textilwerkzeug um ein Wirkwerkzeug, also um ein Textilwerkzeug zum Einsatz in einer Wirkmaschine. Insbesondere und nicht beschränkend kann es sich hierbei um eine Lochnadel, eine Schiebernadel, eine Zungennadel oder Wirkplatine handeln (siehe auch Fig. 1A bis 1C), aber auch um eine Schieberplatine, einen Stechkamm eine Abschlagkammplatine oder eine Fadenkammlamelle.

Obgleich die Beschichtung zumindest im Arbeitsabschnitt aufgebracht sein soll, kann diese auch in Bereichen aufgebracht sein, die per se keinen Kontakt mit dem Textilfaden aufweisen. Üblicherweise weisen die Textilwerkzeuge einen Halteabschnitt zur Einspannung in der Textilmaschine auf, wobei die Beschichtung vorzugsweise lediglich im Halteabschnitt ausgespart ist, also alle übrigen Bereiche des Werkzeugkerns überdeckt.

Vorzugsweise variiert die Dicke der Gradientenschicht im Arbeitsabschnitt, sodass an den jeweils besonders beanspruchten Stellen beispielsweise ein stärkerer Verschleißschutz umgesetzt werden kann als an weniger beanspruchten Stellen.

Besagte Gradientenschicht ist vorzugsweise durch ein PVD-Verfahren erhältlich (Verfahren zur physikalischen Gasphasenabscheidung, kurz PVD-Verfahren). Bei diesem Verfahren wird der zu beschichtende Körper, hier beispielsweise der Werkzeugkern, in einem Arbeitsraum platziert und es werden die aufzubringenden Materialien, hier zumindest das erste Beschichtungsmaterial und das Verschleißschutzmaterial, in jeweiligen Materialquellen bereitgestellt. Aus den Materialquellen heraus werden die aufzubringenden Materialien in die Gasphase überführt, falls diese nicht schon per se in Gasform vorliegen. Durch zeitgleiches Überführen des ersten Beschichtungsmaterials und des Verschleißschutzmaterials kann so eine Hybridschicht bzw. eine Schicht aus einer Materialmischung auf dem zu beschichtenden Körper abgelagert werden. Über das Verhältnis der den Quellen zugeführten Leistungen oder eine andere Gasmenge eines Materials bestimmender Prozessparameter des PVD-Verfahrens kann dabei ein Verhältnis des Verschleißschutzmaterials und des ersten Beschichtungsmaterials in der Gasphase eingestellt und über die Zeit auch variiert werden, um so die in Dickenrichtung variierende Konzentration zu erreichen.

In einer bevorzugten Ausführungsform steigt die Konzentration des Verschleißschutzmaterials in Dickenrichtung ausgehend von einem Werkzeugkern-seitigen Ende der Gradientenschicht in Dickenrichtung bis zu einem Textilfaden-seitigen Ende der Gradientenschicht im Mittel an.

Im Mittel ist hierbei so zu verstehen, dass ein Mittelwert der Konzentration des Verschleißschutzmaterials über die Dicke der Gradientenschicht, z. B. ein integrales Mittel, größer ist als eine Konzentration des Verschleißschutzmaterials am Werkzeugkern-seitigen Ende der Gradientenschicht.

Dadurch nimmt die Verschleißbeständigkeit über die Dicke hinweg zu und fällt im Mittel am Textilfaden-seitigen Ende größer aus, um dort die entsprechende Voraussetzung für einen verschleißbeständigen Kontakt mit einem Textilfaden zu schaffen

In einer bevorzugten Ausführungsform steigt die Konzentration des Verschleißschutzmaterials ausgehend von dem Werkzeugkern-seitigen Ende in Dickenrichtung bis zu dem Textilfaden-seitigen Ende der Gradientenschicht monoton an, insbesondere streng monoton.

Dadurch wird ein besonders gleichmäßiger Übergang zwischen den beiden Eigenschaften Haftung und Verschleißbeständigkeit über die Gradientenschicht hinweg umgesetzt, sodass auch innere Spannung innerhalb der Gradientenschicht selbst erheblich reduziert werden können.

In einer bevorzugten Ausführungsform, bei der das erste Beschichtungsmaterial ein Haftvermittlungsmaterial ist, ist eine Konzentration des Haftvermittlungsmaterials an dem Werkzeugkern-seitigen Ende der Gradientenschicht maximal.

In einer bevorzugten Ausführungsform ist die Konzentration des Verschleißschutzmaterials an dem Textilfaden-seitigen Ende der Gradientenschicht maximal.

Durch die maximalen Konzentrationen der jeweiligen Materialien, wird die jeweils vorrangig zu erzielende Eigenschaft der Gradientenschicht, Haftung und Verschleißbeständigkeit, an den besagten Stellen ebenfalls maximiert.

In einer bevorzugten Ausführungsform beträgt die Konzentration des Verschleißschutzmaterials an dem Textilfaden-seitigen Ende der Gradientenschicht zwischen 50 und 100 Massen-%, insbesondere zwischen 75 und 100 Massen-%, besonders bevorzugt zwischen 90 Massen-% und 100 Massen-%. Insbesondere kann die Konzentration 95 Massen-%, 99 Massen-%, 99,9 Massen-%, 99,99 Massen-% oder 99,999 Massen-% betragen.

Dadurch weist die Gradientenschicht am Textilfaden-seitigen Ende mehrheitlich das Verschleißschutzmaterial in der Materialmischung auf und bietet somit dort eine verstärkte Verschleißbeständigkeit.

Vorzugsweise liegt eine Konzentration des Haftvermittlungsmaterials am Textilfaden-seitigen Ende der Gradientenschicht zwischen 0 Massen-% und 50 Massen-%, weiter bevorzugt zwischen 0 Massen-% und 25 Massen-%, besonders bevorzugt zwischen 0 Massen-% und 10 Massen-%. Insbesondere kann die Konzentration 5 Massen-%, 1 Massen-%, 0,1 Massen-%, 0,01 Massen-% oder 0,001 Massen-% betragen.

In einer bevorzugten Ausführungsform beträgt die Konzentration des Verschleißschutzmaterials an dem Werkzeugkern-seitigen Ende der Gradientenschicht zwischen 0 und 50 Massen-%, insbesondere zwischen 0 und 25 Massen-%, besonders bevorzugt zwischen 90 Massen-% und 100 Massen-%. Insbesondere kann die Konzentration 5 Massen-%, 1 Massen-%, 0,1 Massen-%, 0,01 Massen-% oder 0,001 Massen-% betragen.

Vorzugsweise liegt eine Konzentration des Haftvermittlungsmaterials am Werkzeugkern-seitigen Ende der Gradientenschicht zwischen 50 Massen-% und 100 Massen-%, weiter bevorzugt zwischen 75 Massen-% und 100 Massen-%, besonders bevorzugt zwischen 90 Massen-% und 100 Massen-%. Insbesondere kann die Konzentration 95 Massen-%, 99 Massen-%, 99,9 Massen-%, 99,99 Massen-% oder 99,999 Massen-% betragen.

Dadurch weist die Gradientenschicht am Werkzeugkern-seitigen Ende mehrheitlich das Haftvermittlungsmaterial in der Materialmischung auf und bietet somit dort eine verstärkte Haftung.

In einer bevorzugten Ausführungsform liegt eine Dicke der Gradientenschicht zwischen 0,1 und 20 µm, weiter bevorzugt zwischen 0,5 und 10 µm.

Auf diese Weise ist die Gradientenschicht dick genug, um den darunter liegenden Werkzeugkern ausreichend zu schützen und zeitgleich nicht so dick, als dass dadurch das Risiko von Abplatzungen verstärkt wird.

In einer bevorzugten Ausführungsform enthält die Beschichtung lediglich die Gradientenschicht, und diese ist direkt auf den Werkzeugkern aufgebracht.

Auf diese Weise liegt für das gesamte Werkzeug im Hinblick auf gebietsweise unterschiedliche Werkstoffe lediglich eine Schnittstelle vor, die als mögliche Quellen von Spannungsüberhöhungen fungieren könnte.

In einer bevorzugten Ausführungsform ist das Haftvermittlungsmaterial ein Element oder eine chemische Verbindung mit einem kubischem Kristallsystem und ist insbesondere aus der Gruppe Cr, CrN, Ti, TiAlN ausgewählt.

In einer bevorzugten Ausführungsform ist das Haftvermittlungsmaterial ein Element oder eine chemische Verbindung mit einem hexagonalem Kristallsystem und ist insbesondere aus der Gruppe Ti und AlN ausgewählt.

Besagte Materialien sind vergleichsweise günstig und haben eine besonders gute Wirkung im Hinblick auf den Abbau innerer Spannungen im Übergang zwischen Werkzeugkern und Beschichtung und bieten dabei eine gute Haftung.

In einer bevorzugten Ausführungsform ist das Verschleißschutzmaterial eine chemische Verbindung von Stickstoff und/oder Kohlenstoff mit einem oder mehreren Elementen aus den Gruppen 4, 5, 6, 13 und 14 des Periodensystems der Elemente und ist insbesondere aus der Gruppe AlN, AlTiCrN, CrAlN, Cr₁₋ₓAlₓN, CrN, TiN, TiAlN, TiAlCN, TiAlSiN und Al₂O₃ ausgewählt.

Besonders bevorzugt werden Chrom-haltige Verschleißschutzmaterialien, wie CrAlN, Cr₁₋ₓAlₓN, CrN, da diese eine hohe Festigkeit und zeitgleich ein besonders leichtgängiges Gleiten von Textilfäden erlauben, ohne diese dabei zu beschädigen.

Weiter vorzugsweise kann als Verschleißschutzmaterial Wolframcarbid (WC), DLC (engl.: diamond-like carbon, diamantähnlicher Kohlenstoff) oder Wolfram dotiertes DLC, kurz W-DLC verwendet werden.

W-DLC selbst weist eine im Vergleich zum Kernmaterial hohe Festigkeit auf und hat zudem glättende Eigenschaften zur Senkung von Oberflächenrauheiten, sodass ein darüber laufender Textilfaden weniger stark durch die Rauheiten beschädigt wird.

Weiterhin kann auch tetraedrisch amorpher Kohlenstoff (kurz: ta-C) verwendet werden.

Gemäß eines zweiten Aspekts der Erfindung wird ein Textilwerkzeugverbund bereitgestellt, der eine Vielzahl von Textilwerkzeugen und ein Halteelement umfasst. Die Textilwerkzeuge sind gemäß des ersten Aspekts oder einer von dessen bevorzugten Ausführungsformen ausgeführt und sind nebeneinander am Halteelement befestigt.

Auf diese Weise werden die Textilwerkzeuge zum Einsatz an der Textilmaschine in Verbundform bereitgestellt, sodass durch lediglich eine Montagehandlung, nämlich der Montage des Halteelements in der Textilmaschine, gleich mehrere Textilwerkzeuge in der Textilmaschine montiert werden können, was wiederum die Stillstandzeiten senkt.

Das Halteelement kann dabei als eine Art Fassung für die Textilwerkzeuge verstanden werden.

Die Textilwerkzeuge sind dabei insbesondere parallel zueinander entlang einer ersten Richtung mit einem dazwischen vorgesehenen Abstand im oder am Halteelement befestigt, wobei die Befestigung form- und/oder kraft- und/oder stoffschlüssig zwischen dem Haltelement und jeweiligen Halteabschnitten der Textilwerkzeuge erfolgen kann.

Eine Befestigung erfolgt vorzugsweise über ein Einbringen der Textilwerkzeuge in flüssiges Material des Halteelements und anschließendes Erstarren des selbigen. Wahlweise kann auch eine Befestigung über eine Klebung, beispielsweise mit einem Epoxidharz, erfolgen.

Ein Material des Halteelements ist vorzugsweise ein Kunststoff, insbesondere ein Thermoplast, oder eine Leichtmetalllegierung. Ebenso kann auch Blei oder Zink eingesetzt werden, da diese eine vergleichsweise niedrige Schmelztemperatur aufweist.

Das Haltelement ist dabei derart ausgestaltet, um in eine zugehörige Aufnahme der Textilwerkzeuge, zum Beispiel in Aufnahmeabschnitte einer Barre einer Wirkmaschine, aufgenommen zu werden.

Eine Anordnungsdichte der Textilwerkzeuge in der ersten Richtung beträgt je nach Ausprägung des zu fertigenden Flächengebildes zwischen 1 und 100 Textilwerkzeugen, insbesondere Lochnadeln, pro Zoll (entspricht 2,54 cm). Vorzugsweise liegt die Anordnungsdichte zwischen 6 und 70 Textilwerkzeugen, insbesondere Lochnadeln, pro Zoll und besonders bevorzugt zwischen 18 und 50 Textilwerkzeugen, insbesondere Lochnadeln, pro Zoll.

Eine Länge des Halteelements in der ersten Richtung kann dabei zwischen 0,5 und 50 Zoll betragen, vorzugsweise 0,5, 1, 2, 3,4, 8, oder 16 Zoll.

Vorzugsweise handelt es sich um einen Lochnadelverbund zum Einsatz in einer Wirkmaschine, bei der eine Vielzahl von Lochnadelverbunden wiederum an einer Barre der Wirkmaschine befestigt werden kann, um diese mit den Lochnadeln auszustatten.

Gemäß eines dritten Aspekts der Erfindung wird eine Textilmaschine zur Herstellung von textilen Flächengebilden bereitgestellt, die eine Vielzahl von Textilwerkzeugen umfasst sowie einen Arbeitsbereich, in dem die Textilmaschine eine Vielzahl von Textilfäden mittels der Vielzahl von Textilwerkzeugen zu einem textilen Flächengebilde verarbeitet. Zumindest eines der Textilwerkzeuge (vorzugsweise mehrere und besonders bevorzugt alle) ist ein Textilwerkzeug gemäß des ersten Aspekts oder einer von dessen bevorzugten Ausführungsformen.

Auf diese Weise wird eine Textilmaschine bereitgestellt, die eine maschinelle, automatisierte Herstellung textiler Flächengebilde ermöglicht und dabei die vorstehenden beschriebenen Vorteile beim Einsatz des erfindungsgemäßen Textilwerkzeugs bietet.

Die erfindungsgemäße Textilmaschine zeichnet sich damit unter anderem durch besonders lange Betriebszeiten aus, da die Textilwerkzeuge selbst eine hohe Lebensdauer aufweisen, sowie durch eine durchweg hohe Fertigungsqualität aus, da Beschädigungen der Textilfäden im Zuge der Verarbeitung gering gehalten werden.

Vorzugsweise ist die Textilmaschine eine Wirkmaschine (oder Kettenwirkmaschine), bei der der Arbeitsbereich ein Wirkbereich ist, in dem das textile Flächengebilde als Maschenware hergestellt wird.

Vorzugsweise ist die Textilmaschine eine Strickmaschine, bei der der Arbeitsbereich ein Strickbereich ist, in dem das textile Flächengebilde als Strickware hergestellt wird.

Gemäß eines vierten Aspekts der Erfindung wird ein Verfahren zur Herstellung eines textilen Flächengebildes bereitgestellt, das zumindest ein Bereitstellen einer Textilmaschine gemäß des dritten Aspekts oder einer von dessen bevorzugten Ausführungsformen und ein Verarbeiten einer Vielzahl von Textilfäden im Arbeitsbereich der bereitgestellten Textilmaschine zu einem textilen Flächengebilde mittels der Vielzahl von Textilwerkzeugen der Textilmaschine umfasst.

Das Verarbeiten umfasst dabei üblicherweise ein zueinander relatives Bewegen einzelner Textilwerkzeuge im Arbeitsbereich, insbesondere mittels entsprechender Antriebe und Getriebe, um die Vielzahl von Textilfäden miteinander zu vermaschen, zu verknüpfen, zu verweben, zu verstricken oder dergleichen.

Durch die Verwendung der Textilmaschine mit den erfindungsgemäßen, langlebigen Textilwerkzeugen kann eine große Menge an textilen Flächengebilden hergestellt werden, bevor die Textilwerkzeuge ausgetaucht werden müssen.

Abplatzungen der Beschichtung der Textilwerkzeuge oder ein erhöhter Verschleiß führen üblicherweise zur Beschädigung der geführten Textilfäden, was sich wiederum negativ auf die Qualität des daraus herzustellenden Flächengebildes auswirkt. Durch die Beschichtung des erfindungsgemäßen Textilwerkzeugs wird das Risiko von Abplatzungen der Beschichtung erheblich reduziert und stellt trotzdem eine hohe Verschleißbeständigkeit bereit, wodurch über einen langen Betriebszeitraum hinweg textile Flächengebilde hoher Qualität (ohne beschädigte Textilfäden) hergestellt werden können.

Weitere Aspekte und deren Vorteile als auch speziellere Ausführungsbeispiele der zuvor genannten Aspekte und Merkmale werden im Folgenden unter Zuhilfenahme der in den beigefügten Figuren gezeigten Zeichnungen beschrieben.
Fig. 1A bis 1C zeigen verschiedene Ausführungsbeispiele des erfindungsgemäßen Textilwerkzeugs in Form einer Schiebernadel, einer Lochnadel und einer Wirkplatine.
Fig. 2 zeigt einen Querschnitt durch das Ausführungsbeispiel aus Fig. 1B mit Darstellung einer Beschichtung.
Fig. 3A bis 3F zeigen exemplarische Verläufe einer Konzentration des Verschleißschutzmaterials in der Gradientenschicht.

### Ausführliche Figurenbeschreibung

Fig. 1A bis 1C zeigen verschiedene Ausführungsbeispiele des erfindungsgemäßen Textilwerkzeugs in Form einer Schiebernadel 1a (Fig. 1A), einer Lochnadel 1b (Fig. 1B) und einer Wirkplatine 1c (Fig. 1C).

Alle exemplarisch gezeigten Textilwerkzeuge 1a, 1b, 1c weisen dabei einen Arbeitsabschnitt 10 zum Einwirken auf einen Textilfaden sowie einen Halteabschnitt 20 zum Einspannen in eine Textilmaschine auf.

Die Arbeitsabschnitte 10 sowie die Halteabschnitte 20 sind dabei durch die mit gestrichelten Linien abgesteckten Abschnitte angedeutet und lediglich exemplarisch gewählt. So kann insbesondere der Arbeitsabschnitt 10 der einzelnen Textilwerkzeuge 1a, 1b, 1c größer oder kleiner ausfallen als dargestellt.

Die Textilwerkzeuge 1a, 1b, 1c weisen dabei allesamt einen auf den jeweiligen Werkzeugkern aufgebrachte Beschichtung 200 auf, über die das Textilwerkzeug 1a, 1b, 1c vor Verschleiß geschützt werden soll. Die Beschichtung 200 ist jeweils durch die schraffierte Fläche angedeutet.

Die Beschichtung 200 ist dabei zumindest im Arbeitsabschnitt 10 des jeweiligen Textilwerkezugs 1a, 1b, 1c aufgebracht, kann aber auch über diesen hinausreichen, wie dies beispielsweise in den Fig. 1A und 1B angedeutet ist.

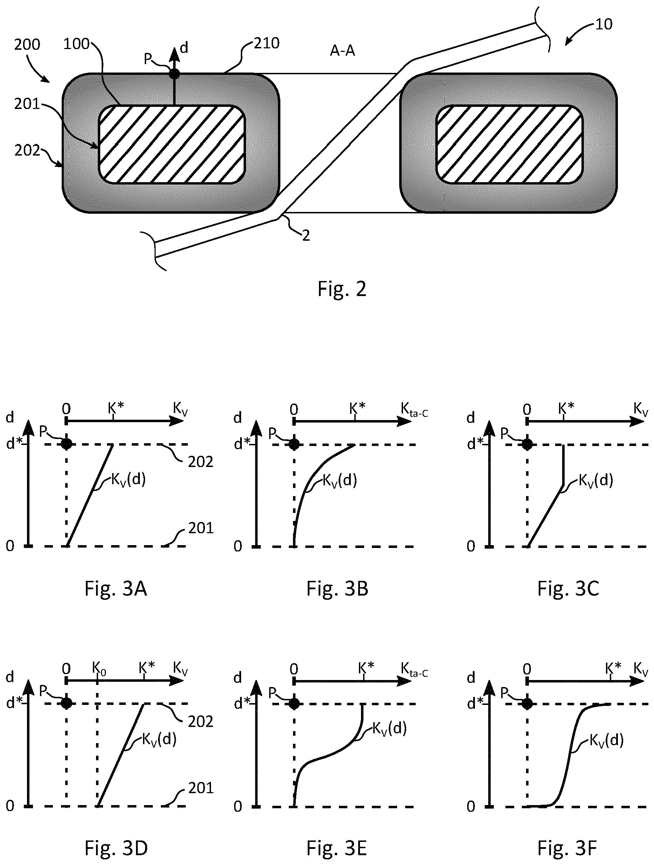

Erfindungsgemäß umfasst die Beschichtung 200 eine Gradientenschicht, die aus einer Materialmischung aus zumindest einem ersten Beschichtungsmaterial, zum Beispiel einem Haftvermittlungsmaterial, und einem Verschleißschutzmaterial als zweitem Beschichtungsmaterial aufgebaut ist, wobei eine Konzentration des Verschleißschutzmaterials in einer Dickenrichtung der Gradientenschicht variiert (siehe auch Fig. 2).

Fig. 2 zeigt einen Querschnitt A-A durch das Ausführungsbeispiel aus Fig. 1B im dortigen Arbeitsabschnitt 10 mit Darstellung einer Beschichtung.

Die Beschichtung 200 umfasst eine Gradientenschicht 210, die aus einer Materialmischung aus einem ersten Beschichtungsmaterial, zum Beispiel einem Haftvermittlungsmaterial, und einem Verschleißschutzmaterial ausgebildet ist.

Durch den Einsatz der Gradientenschicht 210 kann im Vergleich zur konventionellen Ausführung mit getrennten Schichten die Anzahl an Schichtschnittstellen im Textilwerkzeug reduziert werden, wodurch eine Anzahl an Spannungsquelle reduziert und so ein besonders stetiger Verlauf innerer Spannungen ohne Spannungsspitzen umgesetzt werden kann, wodurch sich das Risiko von Abplatzungen der Beschichtung 200 erheblich reduziert.

Im gezeigten dritten Ausführungsbeispiel ist die Konzentration des Verschleißschutzmaterials am Textilfaden-seitigen Ende 202 der Gradientenschicht 210 maximal und die Konzentration des ersten Beschichtungsmaterials, zum Beispiel eines Haftvermittlungsmaterials, ist am Werkzeugkern-seitigen Ende 201 der Gradientenschicht 210 maximal. Der Konzentrationsverlauf kann aber auch beliebig anders ausgestaltet sein.

Dadurch weist die Gradientenschicht 210 im Kontakt mit dem Textilfaden 2 ihre maximale Verschleißbeständigkeit auf und zeitgleich wird eine besonders gute Haftung in der verbleibenden Schnittstelle zum Werkzeugkern 100 umgesetzt.

Es sei angemerkt, dass zwischen der Gradientenschicht 210 und dem Werkzeugkern 100 im Allgemeinen noch weitere Schichten angeordnet sein können, beispielsweise eine reine Haftvermittlungsschicht aus dem bereits verwendeten oder einem weiteren Haftvermittlungsmaterial oder einer Indikatorschicht.

Eine solche Indikatorschicht kann zur Detektion des Verschleißes eingesetzt werden. Kommt es zu einem kompletten Abtrag der Gradientenschicht 210 wird die Indikatorschicht freigelegt, die sich beispielsweise farblich von der Gradientenschicht unterscheidet, sodass ein stellenweise vollständiger Abtrag der Gradientenschicht 210 leicht optisch erkannt werden kann.

Alternativ kann die Indikatorschicht als leitfähige Schicht umgesetzt werden. Wird diese nach vollständigem Abtrag der Gradientenschicht und anschließend zu einem Abtrag der besagten leitfähigen Schicht, kann dies leicht durch die damit verbundenen Änderungen der elektrischen Eigenschaften des Textilwerkzeugs detektiert werden.

Fig. 3A bis 3F zeigen exemplarische Konzentrationsverläufe des Verschleißschutzmaterials in der Gradientenschicht 210 in Dickenrichtung (Pfeilrichtung) am Punkt P aus Fig. 2.

Punkt P ist hierbei willkürlich gewählt und kann auch an einer anderen Stelle im Arbeitsabschnitt 10 liegen.

In den dargestellten Diagrammen bezeichnet d die Koordinate in Dickenrichtung ausgehend vom Werkzeugkern-seitigen Ende 201 der Gradientenschicht bis zum Textilfaden-seitigen Ende 202 der Gradientenschicht 210, wobei eine Gesamtdicke am Punkt P mit d* bezeichnet ist.

Die in Dickenrichtung variierende Konzentration des Verschleißschutzmaterials in der Gradientenschicht 210 ist mit Kv bezeichnet und als Funktion der Koordinate d angegeben. Die Konzentration am Textilfaden-seitigen Ende 202 ist dabei mit K* bezeichnet. Die angegebenen Konzentrationen können als Massen-% verstanden werden.

Fig. 3A zeigt einen linearen Verlauf, bei dem die Konzentration ausgehend von 0 Massen-% linear über die Dickenkoordinate d bis zum Maximum K* bei d=d* ansteigt.

Fig. 3B zeigt einen polynomiellen Verlauf höherer Ordnung, bei dem die Konzentration ausgehend von 0 Massen-% und mit einem Gradienten $\frac{\partial {K}_{V}}{\partial d} \left(d=0\right) = 0$ über die Dicke d bis zum Maximum K* ansteigt. Durch den gewählten Gradienten wird ein besonders gleichmäßiger Übergang an der Schnittstelle am Werkzeugkern-seitigen Ende 201 umgesetzt, was die dort auftretenden inneren Spannungen weiter reduziert.

Die Gradientenschicht 210 kann hierbei auch bei jedwedem anderen Konzentrationsverlauf mit einem am Werkzeugkern-seitigen Ende 201 verschwindenden Gradienten bezogen auf die Dickenrichtung ausgebildet sein, unabhängig davon, ob die Konzentration des Verschleißschutzmaterials dort 0 Massen-% beträgt oder nicht.

Fig. 3C zeigt einen abschnittsweise definierten Verlauf, bei dem ein anfänglich linearer Verlauf in eine konstante Konzentration K* übergeht und diese bis zum Textilfadenseitigen Ende 202 beibehält. Auf diese Weise wird ein Bereich mit konstanter Konzentration des Verschleißschutzmaterials am Textilfaden-seitigen Ende 202 bereitgestellt.

Fig. 3D zeigt, wie auch Fig. 3A einen linearen Verlauf, bei dem die Konzentration am Werkzeugkern-seitigen Ende 201 nicht 0 Massen-% beträgt, sondern K₀ mit 0< K₀ < K* beträgt.

Fig. 3E zeigt einen Verlauf bei dem die Konzentration ausgehend von 0 Massen-% und mit einem Gradienten $\frac{\partial {K}_{V}}{\partial d} \left(d=0\right) = 0$ über die Dicke d bis zum Maximum K* ansteigt und dieses ebenfalls mit einem Gradienten $\frac{\partial {K}_{V}}{\partial d} \left(d=d*\right) = 0$ erreicht. Durch die gewählten Gradienten wird ein besonders gleichmäßiger Übergang an der Schnittstelle am Werkzeugkern-seitigen Ende 201 umgesetzt und zudem am Textilfadenseitigen Ende ein Bereich mit zumindest abschnittsweise annährend unveränderlicher Konzentration des Verschleißschutzmaterials bereitgestellt. Die maximale Steigung des Konzentrationsverlaufs in Abhängigkeit der Dicke d wird dabei ungefähr in der Mitte der Gradientenschicht 210 erreicht.

Die Gradientenschicht 210 kann hierbei auch bei jedwedem anderen Konzentrationsverlauf mit einem am Textilfaden-seitigen Ende 202 verschwindenden Gradienten bezogen auf die Dickenrichtung ausgebildet sein.

Fig. 3F zeigt einen zu Fig. 3E qualitativ abweichenden Konzentrationsverlauf, bei dem die Steigung des Konzentrationsverlaufs in Abhängigkeit der Dicke d in den Randbereichen zum Werkezugkern- bzw. zum Textilfaden-seitigen Ende hin größer ausfällt als in der Mitte der Gradientenschicht 210.

Die gezeigten Konzentrationsverläufe sind dabei allesamt stetig umgesetzt, um so einen stetigen Verlauf der inneren Spannungen und damit einen verbesserten Verbund innerhalb der Beschichtung zu gewährleisten, umso beispielsweise das Risiko von Abplatzungen zu verhindern.

Der Konzentrationsverlauf soll dabei allerdings nicht auf die gezeigten Verläufe beschränkt verstanden werden.

Bei den gezeigten Konzentrationsverläufen kann es sich auch ebenso um eine über die zwei übrigen Dimensionen eines Abschnitts der Gradientenschicht oder der gesamten Gradientenschicht gemittelten Konzentrationsverlauf handeln. In anderen Worten, können die Konzentrationsverläufe auch als oberflächenmäßige, mittlere Konzentrationsverläufe verstanden werden.

Vorstehend wurden Ausführungsbeispiele der vorliegenden Erfindung sowie deren Vorteile detailliert unter Bezugnahme auf die beigefügten Figuren beschrieben.

Abschließend wird erneut hervorgehoben, dass die vorliegende Erfindung in keiner Weise auf die vorstehend beschriebenen Ausführungsbeispiele und deren Ausführungsmerkmale begrenzt ist. Die Erfindung umfasst weiterhin Modifikationen der genannten Ausführungsbeispiele, insbesondere diejenigen, die aus Modifikationen und/oder Kombinationen einzelner oder mehrerer Merkmale der beschriebenen Ausführungsbeispiele im Rahmen des Schutzumfanges der unabhängigen Ansprüche hervorgehen.

### Liste der Bezugszeichen

- 1a: Schiebernadel
- 1b: Lochnadel
- 1c: Wirkplatine
- 2: Textilfaden
- 10: Arbeitsabschnitt
- 20: Halteabschnitt
- 100: Werkzeugkern
- 200: Beschichtung
- 201: Werkzeugkern-seitiges Ende
- 202: Textilfaden-seitiges Ende
- 210: Gradientenschicht

## Patentansprüche

1. Textilwerkzeug (1a, 1b, 1c) zum Einsatz in einer Textilmaschine, das einen Arbeitsabschnitt (10) zum Einwirken auf einen Textilfaden (2) im Zuge einer Herstellung eines textilen Flächengebildes aufweist, wobei das Textilwerkzeug (1a, 1b, 1c) einen Werkzeugkern (100) aus einem Kernmaterial umfasst, auf den zumindest im Arbeitsabschnitt (10) eine Beschichtung (200) zum Verschleißschutz aufgebracht ist,
wobei die Beschichtung (200) eine Gradientenschicht (210) umfasst, die aus einer Materialmischung aus zumindest einem ersten Beschichtungsmaterial und einem Verschleißschutzmaterial als zweitem Beschichtungsmaterial, das ein anderes Material ist als das erste Beschichtungsmaterial, aufgebaut ist, wobei eine Konzentration des Verschleißschutzmaterials in einer Dickenrichtung der Gradientenschicht (210) variiert,
**dadurch gekennzeichnet, dass**
der Werkzeugkern (100) des Textilwerkzeugs (1a, 1b, 1c) derart ausgestaltet ist, dass ein minimaler Krümmungsradius einer Oberfläche im Arbeitsabschnitt des Textilwerkzeugs (1a, 1b, 1c) größer gleich 40 µm ist.

2. Textilwerkzeug (1a, 1b, 1c) nach Anspruch 1, wobei
die Konzentration des Verschleißschutzmaterials in Dickenrichtung ausgehend von einem Werkzeugkern-seitigen Ende (201) der Gradientenschicht in Dickenrichtung bis zu einem Textilfaden-seitigen Ende (202) der Gradientenschicht (210) im Mittel ansteigt.

3. Textilwerkzeug (1a, 1b, 1c) nach Anspruch 2, wobei
die Konzentration des Verschleißschutzmaterials ausgehend von dem Werkzeugkern-seitigen Ende (201) in Dickenrichtung bis zu dem Textilfaden-seitigen Ende (202) der Gradientenschicht (210) monoton ansteigt, insbesondere streng monoton.

4. Textilwerkzeug (1a, 1b, 1c) nach zumindest einem der Ansprüche 1 bis 3, wobei
die Konzentration des Verschleißschutzmaterials an dem Textilfaden-seitigen Ende (202) der Gradientenschicht (210) zwischen 50 und 100 Massen-% beträgt, insbesondere zwischen 75 und 100 Massen-%.

5. Textilwerkzeug (1a, 1b, 1c) nach zumindest einem der Ansprüche 1 bis 4, wobei
die Konzentration des Verschleißschutzmaterials an dem Werkzeugkern-seitigen Ende (202) der Gradientenschicht (210) zwischen 0 und 50 Massen-% beträgt.

6. Textilwerkzeug (1a, 1b, 1c) nach Anspruch 5, wobei
die Konzentration des Verschleißschutzmaterials an dem Werkzeugkern-seitigen Ende (202) der Gradientenschicht (210) zwischen 0 und 25 Massen-%.

7. Textilwerkzeug (1a, 1b, 1c) nach zumindest einem der Ansprüche 1 bis 6, wobei
eine Dicke der Gradientenschicht zwischen 0,1 und 20 µm beträgt.

8. Textilwerkzeug (1a, 1b, 1c) nach zumindest einem der Ansprüche 1 bis 7, wobei
die Beschichtung (200) lediglich die Gradientenschicht (210) enthält und diese direkt auf den Werkzeugkern (100) aufgebracht ist.

9. Textilwerkzeug (1a, 1b, 1c) nach zumindest einem der Ansprüche 1 bis 8, wobei
das erste Beschichtungsmaterial ein Haftvermittlungsmaterial ist.

10. Textilwerkzeug (1a, 1b, 1c) nach Anspruch 9, wobei
eine Konzentration des Haftvermittlungsmaterials an dem Werkzeugkern-seitigen Ende (201) der Gradientenschicht (210) maximal ist und/oder die Konzentration des Verschleißschutzmaterials an dem Textilfaden-seitigen Ende (201) der Gradientenschicht (210) maximal ist.

11. Textilwerkzeug (1a, 1b, 1c) nach einem der Ansprüche 9 oder 10, wobei
das Haftvermittlungsmaterial ein Element oder eine chemische Verbindung mit einem kubischem Kristallsystem ist und insbesondere aus der Gruppe Cr, CrN, Ti, TiAlN ausgewählt ist, oder
wobei das Haftvermittlungsmaterial ein Element oder eine chemische Verbindung mit einem hexagonalem Kristallsystem ist und insbesondere aus der Gruppe Ti und AlN ausgewählt ist.

12. Textilwerkzeug (1a, 1b, 1c) nach zumindest einem der Ansprüche 1 bis 11, wobei
das Verschleißschutzmaterial eine chemische Verbindung von Stickstoff und/oder Kohlenstoff mit einem oder mehreren Elementen aus den Gruppen 4, 5, 6, 13 und 14 des Periodensystems der Elemente ist und insbesondere aus der Gruppe AlN, AlTiCrN, CrAlN, Cr₁₋ₓAlₓN, CrN, TiN, TiAlN, TiAlCN, TiAlSiN und Al₂O₃ ausgewählt ist.

13. Textilwerkzeugverbund, umfassend:
- eine Vielzahl von Textilwerkzeugen (1a, 1b, 1c) nach einem der Ansprüche 1 bis 12; und
- ein Halteelement, an dem die Textilwerkzeuge (1a, 1b, 1c) nebeneinander befestigt sind.

14. Textilmaschine zur Herstellung von textilen Flächengebilden, zumindest umfassend:
- eine Vielzahl von Textilwerkzeugen (1a, 1b, 1c) nach einem der Ansprüche 1 bis 12; und
- einen Arbeitsbereich, in dem die Textilmaschine eine Vielzahl von Textilfäden mittels der Vielzahl von Textilwerkzeugen (1a, 1b, 1c) zu einem textilen Flächengebilde verarbeitet.

15. Verfahren zur Herstellung eines textilen Flächengebildes, umfassend:
- Bereitstellen einer Textilmaschine nach Anspruch 14;
- Verarbeiten einer Vielzahl von Textilfäden im Arbeitsbereich der Textilmaschine zu einem textilen Flächengebilde mittels der Vielzahl von Textilwerkzeugen (1a, 1b, 1c) der Textilmaschine.

## Claims

1. Textile tool (1a, 1b, 1c) for use in a textile machine, which has a working section (10) for acting on a textile thread (2) in the course of producing a textile fabric, wherein the textile tool (1a, 1b, 1c) comprises a tool core (100) made of a core material, to which a coating (200) for wear protection is applied at least in the working section (10),
wherein the coating (200) comprises a gradient layer (210), which is constructed from a material mixture of at least a first coating material and a wear protection material as a second coating material, which is a different material than the first coating material, wherein a concentration of the wear protection material varies in a thickness direction of the gradient layer (210),
**characterized in that**
the tool core (100) of the textile tool (1a, 1b, 1c) is configured in such a way that a minimum radius of curvature of a surface in the working section of the textile tool (1a, 1b, 1c) is greater than or equal to 40 µm.

2. Textile tool (1a, 1b, 1c) according to Claim 1, wherein
the concentration of the wear protection material increases on average in the thickness direction starting from a tool core-side end (201) of the gradient layer in the thickness direction as far as a textile thread-side end (202) of the gradient layer (210).

3. Textile tool (1a, 1b, 1c) according to Claim 2, wherein
the concentration of the wear protection material increases monotonically, in particular strictly monotonically, starting from the tool core-side end (201) in the thickness direction as far as the textile thread-side end (202) of the gradient layer (210).

4. Textile tool (1a, 1b, 1c) according to at least one of Claims 1 to 3, wherein
the concentration of the wear protection material at the textile thread-side end (202) of the gradient layer (210) is between 50 and 100% by mass, in particular between 75 and 100% by mass.

5. Textile tool (1a, 1b, 1c) according to at least one of Claims 1 to 4, wherein
the concentration of the wear protection material at the tool core-side end (202) of the gradient layer (210) is between 0 and 50% by mass.

6. Textile tool (1a, 1b, 1c) according to Claim 5, wherein
the concentration of the wear protection material at the tool core-side end (202) of the gradient layer (210) is between 0 and 25% by mass.

7. Textile tool (1a, 1b, 1c) according to at least one of Claims 1 to 6, wherein
a thickness of the gradient layer is between 0.1 and 20 µm.

8. Textile tool (1a, 1b, 1c) according to at least one of Claims 1 to 7, wherein
the coating (200) contains only the gradient layer (210) and this is applied directly to the tool core (100).

9. Textile tool (1a, 1b, 1c) according to at least one of Claims 1 to 8, wherein
the first coating material is an adhesion-promoting material.

10. Textile tool (1a, 1b, 1c) according to Claim 9, wherein
a concentration of the adhesion-promoting material at the tool core-side end (201) of the gradient layer (210) is at a maximum and/or the concentration of the wear protection material at the textile thread-side end (201) of the gradient layer (210) is at a maximum.

11. Textile tool (1a, 1b, 1c) according to either of Claims 9 and 10, wherein
the adhesion-promoting material is an element or a chemical compound having a cubic crystal system and is selected in particular from the group Cr, CrN, Ti, TiAlN, or
wherein the adhesion-promoting material is an element or a chemical compound having a hexagonal crystal system and is selected in particular from the group Ti and AlN.

12. Textile tool (1a, 1b, 1c) according to at least one of Claims 1 to 11, wherein
the wear protection material is a chemical compound of nitrogen and/or carbon with one or more elements from groups 4, 5, 6, 13 and 14 of the Periodic Table of the Elements and is selected in particular from the group AIN, AlTiCrN, CrAlN, Cr₁₋ₓAlₓN, CrN, TiN, TiAlN, TiAlCN, TiAlSiN and Al₂O₃ .

13. Textile tool assembly, comprising:
- a multiplicity of textile tools (1a, 1b, 1c) according to one of Claims 1 to 12; and
- a holding element, to which the textile tools (1a, 1b, 1c) are fastened next to one another.

14. Textile machine for producing textile fabrics, at least comprising:
- a multiplicity of textile tools (1a, 1b, 1c) according to one of Claims 1 to 12; and
- a working region, in which the textile machine processes a multiplicity of textile threads by means of the multiplicity of textile tools (1a, 1b, 1c) to form a textile fabric.

15. Method for producing a textile fabric, comprising:
- providing a textile machine according to Claim 14;
- processing a multiplicity of textile threads in the working region of the textile machine to form a textile fabric by means of the multiplicity of textile tools (1a, 1b, 1c) of the textile machine.

## Revendications

1. Outil textile (1a, 1b, 1c) destiné à être utilisé dans une machine textile, qui présente une section de travail (10) pour agir sur un fil textile (2) au cours d'une fabrication d'une structure textile plane, l'outil textile (1a, 1b, 1c) comprenant un noyau d'outil (100) en un matériau de noyau, sur lequel un revêtement (200) pour la protection contre l'usure est appliqué au moins dans la section de travail (10),
le revêtement (200) comprenant une couche de gradient (210) qui est constituée d'un mélange de matériaux constitué d'au moins un premier matériau de revêtement et d'un matériau de protection contre l'usure en tant que deuxième matériau de revêtement, qui est un matériau différent du premier matériau de revêtement, une concentration du matériau de protection contre l'usure variant dans une direction d'épaisseur de la couche de gradient (210),
**caractérisé en ce que**
le noyau d'outil (100) de l'outil textile (1a, 1b, 1c) est configuré de telle sorte qu'un rayon de courbure minimal d'une surface dans la section de travail de l'outil textile (1a, 1b, 1c) est supérieur ou égal à 40 µm.

2. Outil textile (1a, 1b, 1c) selon la revendication 1,
la concentration du matériau de protection contre l'usure dans la direction d'épaisseur augmentant en moyenne à partir d'une extrémité côté noyau d'outil (201) de la couche de gradient dans la direction d'épaisseur jusqu'à une extrémité côté fil textile (202) de la couche de gradient (210).

3. Outil textile (1a, 1b, 1c) selon la revendication 2,
la concentration du matériau de protection contre l'usure augmentant de manière monotone à partir de l'extrémité côté noyau d'outil (201) dans la direction d'épaisseur jusqu'à l'extrémité côté fil textile (202) de la couche de gradient (210), en particulier de manière strictement monotone.

4. Outil textile (1a, 1b, 1c) selon au moins l'une quelconque des revendications 1 à 3,
la concentration du matériau de protection contre l'usure au niveau de l'extrémité côté fil textile (202) de la couche de gradient (210) étant comprise entre 50 et 100 % en masse, en particulier entre 75 et 100 % en masse.

5. Outil textile (1a, 1b, 1c) selon au moins l'une quelconque des revendications 1 à 4,
la concentration du matériau de protection contre l'usure au niveau de l'extrémité côté noyau d'outil (202) de la couche de gradient (210) étant comprise entre 0 et 50 % en masse.

6. Outil textile (1a, 1b, 1c) selon la revendication 5,
la concentration du matériau de protection contre l'usure au niveau de l'extrémité côté noyau d'outil (202) de la couche de gradient (210) étant comprise entre 0 et 25 % en masse.

7. Outil textile (1a, 1b, 1c) selon au moins l'une quelconque des revendications 1 à 6,
une épaisseur de la couche de gradient étant comprise entre 0,1 et 20 µm.

8. Outil textile (1a, 1b, 1c) selon au moins l'une quelconque des revendications 1 à 7,
le revêtement (200) ne contenant que la couche de gradient (210) et celle-ci étant appliquée directement sur le noyau d'outil (100).

9. Outil textile (1a, 1b, 1c) selon au moins l'une quelconque des revendications 1 à 8,
le premier matériau de revêtement étant un matériau promoteur d'adhérence.

10. Outil textile (1a, 1b, 1c) selon la revendication 9,
une concentration du matériau promoteur d'adhérence au niveau de l'extrémité côté noyau d'outil (201) de la couche de gradient (210) étant maximale et/ou la concentration du matériau de protection contre l'usure au niveau de l'extrémité côté fil textile (201) de la couche de gradient (210) étant maximale.

11. Outil textile (1a, 1b, 1c) selon l'une quelconque des revendications 9 ou 10,
le matériau promoteur d'adhérence étant un élément ou un composé chimique avec un système cristallin cubique et étant en particulier choisi dans le groupe constitué par Cr, CrN, Ti, TiAlN, ou
le matériau promoteur d'adhérence étant un élément ou un composé chimique avec un système cristallin hexagonal et étant en particulier choisi dans le groupe constitué par Ti et AlN.

12. Outil textile (1a, 1b, 1c) selon au moins l'une quelconque des revendications 1 à 11,
le matériau de protection contre l'usure étant un composé chimique d'azote et/ou de carbone avec un ou plusieurs éléments des groupes 4, 5, 6, 13 et 14 du tableau périodique des éléments et étant en particulier choisi dans le groupe constitué par AlN, AlTiCrN, CrAlN, Cr₁₋ₓAlxN, CrN, TiN, TiAlN, TiAlCN, TiAlSiN et Al₂O₃ .

13. Ensemble d'outils textiles, comprenant :
- une pluralité d'outils textiles (1a, 1b, 1c) selon l'une quelconque des revendications 1 à 12 ; et
- un élément de retenue, sur lequel les outils textiles (1a, 1b, 1c) sont fixés les uns à côté des autres.

14. Machine textile pour la fabrication de structures textiles planes, comprenant au moins :
- une pluralité d'outils textiles (1a, 1b, 1c) selon l'une quelconque des revendications 1 à 12 ; et
- une zone de travail, dans laquelle la machine textile traite une pluralité de fils textiles au moyen de la pluralité d'outils textiles (1a, 1b, 1c) en une structure textile plane.

15. Procédé de fabrication d'une structure textile plane, comprenant :
- la fourniture d'une machine textile selon la revendication 14 ;
- le traitement d'une pluralité de fils textiles dans la zone de travail de la machine textile en une structure textile plane au moyen de la pluralité d'outils textiles (1a, 1b, 1c) de la machine textile.
